# EUROPEAN PATENT SPECIFICATION

(11) **EP 1 846 321 B1**
(45) Date of publication and mention of the grant of the patent: **22.12.2010**
(21) Application number: 05702532.2
(22) Date of filing: 31.01.2005
(51) Int. Cl.: B81C 1/00, H01L 21/20, H01L 21/762, H01L 21/268, C30B 25/10

(54) **METHOD OF FABRICATING A SILICON-ON-INSULATOR STRUCTURE**
VERFAHREN ZUR HERSTELLUNG EINER SOI-STRUKTUR
PROCEDE DE FABRICATION D'UNE STRUCTURE SILICIUM-SUR-ISOLANT

(43) Date of publication of application: 24.10.2007
(73) Proprietor: Freescale Semiconductor Inc., Austin, TX 78735 (US)
(72) Inventor: RENAUD, Philippe, 31270 Cugneaux (FR); BERTRAND, Isabelle, 38330 Montbonnot (FR)
(74) Representative: Ferro, Frodo Nunes
(86) International application number: PCT/IB2005/000446
(87) International publication number: WO 2006/079870

(56) References cited:
- US-A- 5 186 785
- US-A- 5 294 556
- PATENT ABSTRACTS OF JAPAN vol. 007, no. 111 (E-175), 14 May 1983 (1983-05-14) -& JP 58 031515 A (NIPPON DENKI KK), 24 February 1983 (1983-02-24)
- "PROCESS FOR FABRICATION OF VERY THIN EPITAXIAL SILICON FILMS OVER INSULATING LAYERS" IBM TECHNICAL DISCLOSURE BULLETIN, IBM CORP. NEW YORK, US, vol. 35, no. 2, 1 July 1992 (1992-07-01), pages 247-249, XP000313285 ISSN: 0018-8689
- YOSHIHIRO ARIMOTO: "ZONE MELTING RECRYSTALLIZATION FOR DIELECTRICALLY ISOLATED BIPOLAR TRANSISTORS" JOURNAL OF THE ELECTROCHEMICAL SOCIETY, ELECTROCHEMICAL SOCIETY. MANCHESTER, NEW HAMPSHIRE, US, vol. 139, no. 11, 1 November 1992 (1992-11-01), pages 3288-3294, XP000360629 ISSN: 0013-4651
- PATENT ABSTRACTS OF JAPAN vol. 011, no. 031 (E-475), 29 January 1987 (1987-01-29) -& JP 61 198712 A (FUJITSU LTD), 3 September 1986 (1986-09-03)

## Description

### Field of the Invention

This invention relates to, in general, a method of fabricating a silicon-on-insulator structure of the type, for example, used in the fabrication of sensors, such as acceleration sensors.

### Background of the Invention

In the field of sensor fabrication, for example silicon acceleration sensors, a Silicon-On-Insulator (SOI) wafer is typically required as an initial structure. However, such initial structures need to be patterned prior to addition of an epitaxial layer, resulting in the SOI wafer being costly.

Several known techniques exist for forming SOI wafers. For example, US 5,493,470 discloses a diaphragm pressure sensor formed by use of a so-called Zone Melting Re-crystallisation (ZMR) silicon-on-insulator technology, where re-crystallised silicon is used to form a diaphragm. US 6,232,140 relates to a capacitive acceleration sensor formed in a monocrystalline SOI wafer, the monocrystalline SOI wafer comprising two bonded silicon wafers having an air gap therebetween due to the presence of a patterned oxide layer. US 6,029,517 discloses a miniaturised accelerometer of the type having spring compensation for gravitational effects, an SOI wafer being used as a starting material. US 6,130,464 relates to a surface micro-machined micro-accelerometer including a cantilever formed on a substrate and having a fixed end and a free end, the fixed end being anchored to the substrate; an SOI wafer (formed using one of the: BESOI, SmartCut or SIMOX fabrication techniques) is the starting material. US 6,294,400 discloses a precision micro-mechanical semiconductor accelerometer of the differential-capacitor type comprising a pair of etched opposing cover layers fusion bonded to opposite sides of an etched proof mass layer to form an hermetically sealed assembly. WO-A-03 069355 relates to fabrication of a low-cost breakable inertial threshold acceleration sensor mainly using micro-machining silicon technology. The sensor is of the capacitive type and made of commercially available SOI wafers. US 5,747,353 discloses a surface micro-machined accelerometer using an SOI wafer structure.

However, the above described SOI wafers are either complex to form or require specialised substrates as a starting material for the fabrication of the SOI wafer. Consequently, the cost per device is relatively high.

JP 58 031515 A relates to a so-called LOCOS process for separating adjacent devices in a CMOS structure, where a silicon-on-insulator structure is fabricated.

XP 313285 A relates to a process for fabrication of very thin epitaxial silicon films over insulating layers.

### Statement of Invention

According to the present invention, there is provided a method of fabricating a silicon-on-insulator structure as set forth in the claims herein.

### Brief Description of the Drawings

At least one embodiment of the invention will now be described, by way of example only, with reference to the accompanying drawings, in which:
FIGs. 1A to 1G are schematic diagrams of processing steps constituting a first embodiment of the invention;
FIG. 2 is a flow diagram of a method of forming a patterned Silicon-On-Insulator wafer;
FIG. 3 is a scanning electron micrograph image of silicon grown over an insulator pattern prior to a re-crystallisation step
FIG. 4 is a schematic diagram of an insulator structure constituting a second embodiment of the invention;
FIG. 5 is a schematic diagram of another insulating structure constituting a third embodiment of the invention;
FIGs. 6A & 6B are schematic diagrams of a first alignment arrangement for use with any of the above wafer embodiments;
FIG. 7 is a schematic diagram of a second alignment structure for use with any of the above wafer embodiment; ;and
FIG. 8 is a scanning electron micrograph image of an alignment pattern of FIG. 7.

### Description of Preferred Embodiments

Throughout the following description, identical reference numerals will be used to identify like parts.

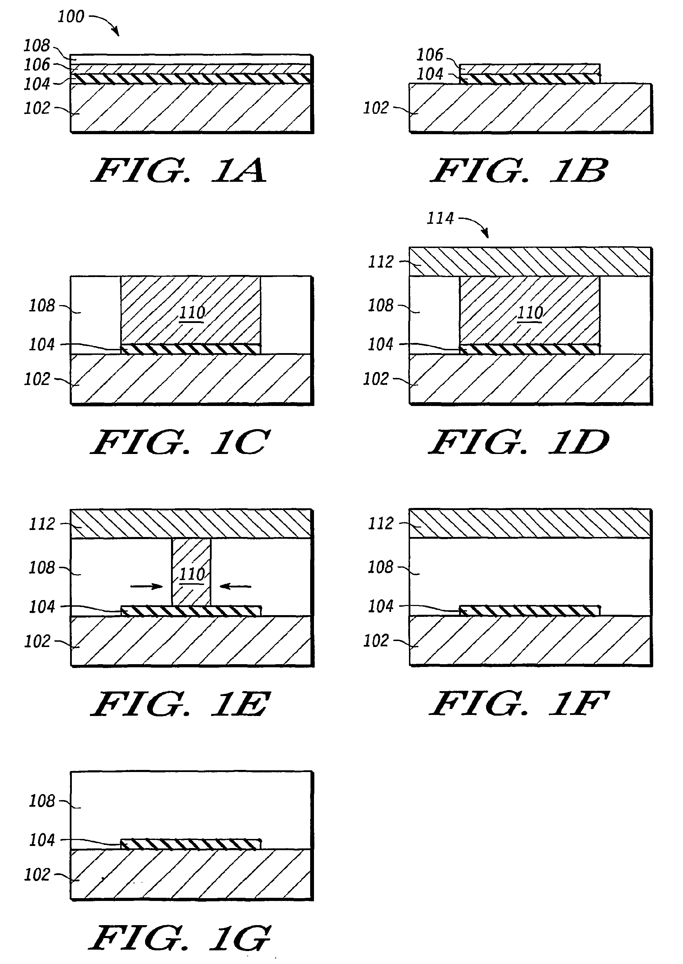

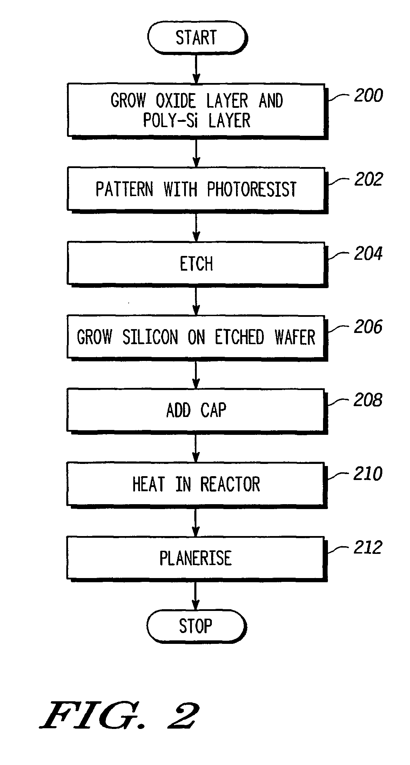

Referring to FIGs. 1(A) and 2, an initial wafer structure 100 is obtained (Step 200) by depositing an insulating layer 104, for example, a dielectric layer, such as silicon dioxide, silicon nitride, diamond film, or tantalum nitride over a monocrystalline silicon substrate 102. If the insulating layer is an oxide, the oxide can be a thermal oxide or a Low Pressure Chemical Vapour Deposition (LPCVD) oxide. The monocrystalline silicon substrate 102 is any suitable silicon substrate, in this example, for the formation of a sensor. A polysilicon (Poly-Si) seed layer 106 is then grown over the insulating layer 104 and an exposed surface of the Poly-Si seed layer 106 patterned (Step 202) using a layer of photoresist 108.

Turning to FIG. 1(B), the Poly-Si seed layer 106 is then etched (Step 204) by subjecting the initial wafer structure 100 to a Reactive Ion Etching (RIE) process. Subsequently, the insulating material 104 is etched (Step 204) using a wet etching process, for example one employing a hydrofluoric acid (HF) buffer to expose a hitherto covered surface of the silicon substrate 102. However, it is possible to achieve a similar result using the RIE process described above. In this respect, it should be appreciated that the remaining parts of the insulating layer 104 and the Poly-Si seed layer 106 are still considered "layers".

Thereafter (FIG. 1(C)), the etched wafer is placed in an Epitaxial (EPI) reactor (not shown), for example a Chemical Vapour Deposition (CVD) Epitaxial reactor, and silicon is grown (Step 206) over the exposed surface of the silicon substrate 102 and the Poly-Si seed layer 106 to a thickness of about 30µm. However, it should be appreciated that epitaxial growth takes place in the form of a monocrystalline silicon layer 108 forming over the exposed surface of the silicon substrate 102, whereas a polysilicon layer 110 forms in the EPI reactor over the surface of the Poly-Si seed layer 106 due to the polycrystalline structure of the Poly-Si seed layer 106. The thickness of the silicon grown can vary depending upon the dimensional requirements of the sensor ultimately being manufactured. Therefore, the overgrown silicon can be at least about 10µm thick, for example between about 10µm and about 60µm, such as between about 20µm and about 50µm.

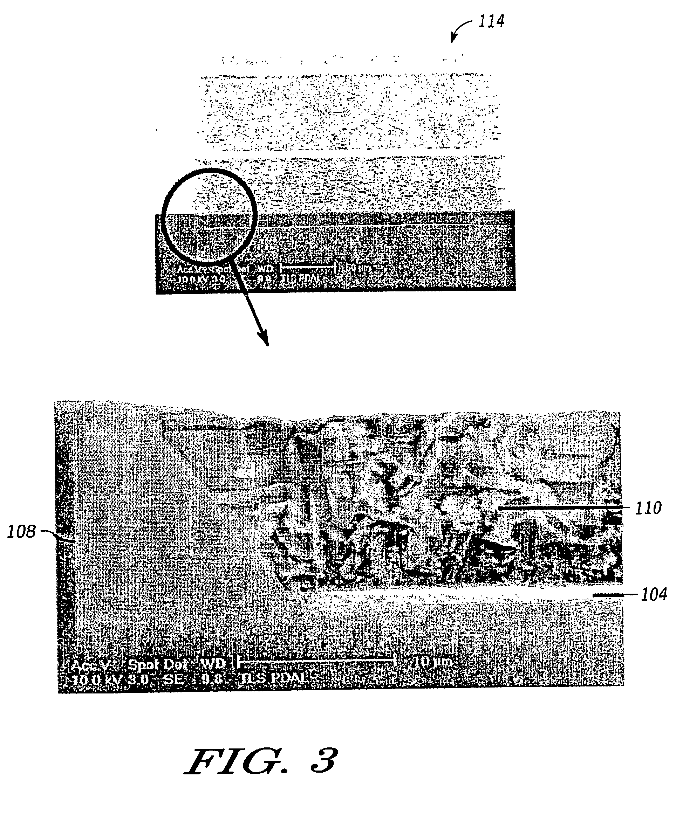

Referring to FIG. 1(D), a capping layer 112, for example a silicon dioxide layer (SiO₂) , is grown (Step 208) over the overgrown monocrystalline silicon and polysilicon 108, 110 to form a capped wafer 114 that prevents evaporation of the silicon into a chamber of the furnace and consequent damage thereto; the resulting structure formed can be partially seen from FIG. 3.

The capped wafer 114 is then placed (Step 210) in a Rapid Thermal Processing (RTP) furnace (not shown) for a predetermined period of time. In the furnace, the capped wafer 114 is subjected to, in this example, a temperature of 1410°C in order to cause the overgrown polysilicon to re-crystallises into monocrystalline silicon; the monocrystalline silicon formed over the previously exposed surface of the substrate 102 acts as a seed for the re-crystallising polysilicon as the temperature in the furnace ramps-down. The predetermined period of time is set so that all of the overgrown polysilicon is heated so as to completely re-crystallise into monocrystalline silicon.

The capped wafer 114 is then removed from the furnace and the capping layer 114 is removed by a wet-etching technique. Thereafter, the uncapped wafer is subjected to a Chemical Micro-Polishing (CMP) process in order to planarise (Step 212) the wafer, thereby removing about 3µm of the surface of the monocrystalline silicon 108, leaving a wafer having a smooth upper surface and comprising the insulating material 104 buried beneath a layer of the monocrystalline silicon 108. The resulting silicon-on-insulator wafer is particularly suitable as a starting wafer for the production of a sensor, for example an acceleration sensor.

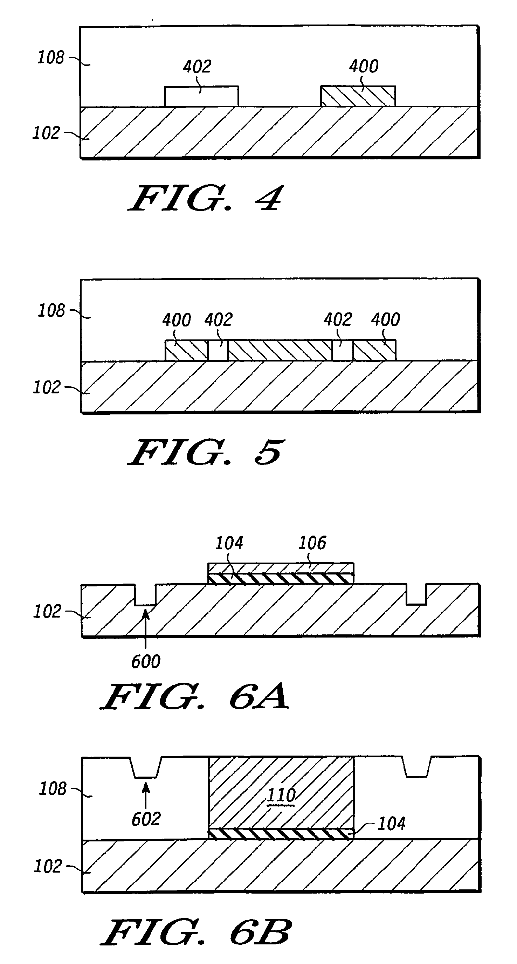

In another embodiment (FIG. 4), the insulating layer 104 is formed from a deposition of a first insulating material 400, for example a thermal oxide, such as silicon dioxide (SiO₂) and a deposition of a second insulating material 402, for example a nitride, such as silicon nitride. Each of the first and second insulating materials are respectively formed by patterning a first region with the first insulating material and patterning a second region with the second insulating material. In this example, the first region of the first insulating material 400 is spaced apart from the second region of the second insulating material 402. In such situations, it is desirable to provide a spacing of at least about 1µm between the first and second regions, for example at least about 20µm.

However, in a further embodiment (FIG. 5), the region of the first insulating material 400 is disposed adjacent the second region of the second insulating material 402. Indeed, in this example, the first region of the first insulating material 400 surrounds the second region of the second insulating material 402.

Referring to FIG. 6A, in order to provide one or more points of reference for the purpose of alignment, one or more alignment recesses 600 are created by etching one or more recesses into the silicon substrate 102 using any suitable known etching technique. When the monocrystalline silicon layer 108 is subsequently grown (Step 206) on the substrate 102 (FIG. 6B) as described above, one or more corresponding recesses 602 are formed in the monocrystalline silicon layer 108 by virtue of the variation in level of, in this example, the exposed surface of the silicon substrate 102.

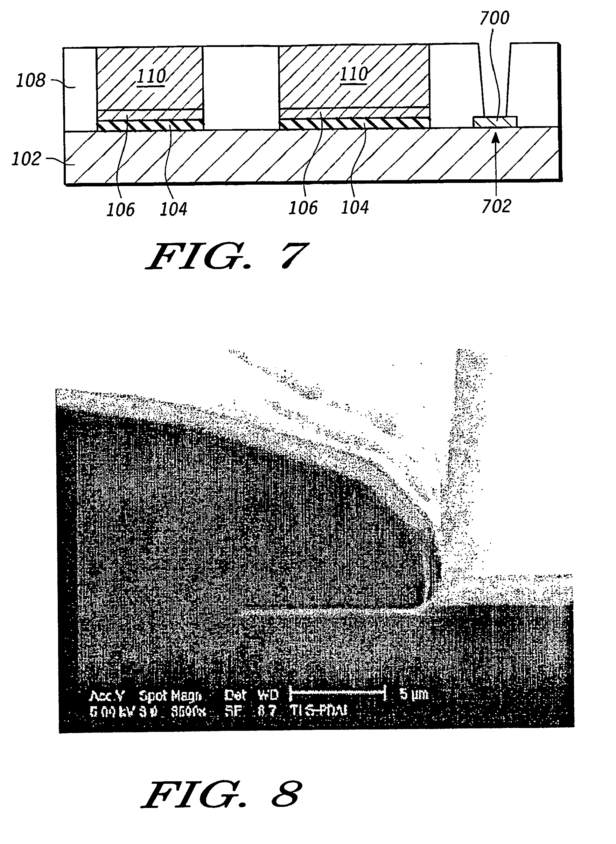

Alternatively or additionally (FIG. 7), one or more further regions 700 of the insulating material are deposited, but not covered with the Poly-Si seed layer 106, thereby substantially preventing subsequent growth of silicon on the one or more further regions 700 at the silicon overgrowth stage (Step 206). Consequently, one or more recesses 702 form in the overgrown silicon, even after the re-crystallisation stage (Step 210), as can be seen in FIG. 8. It should be appreciated that this technique for forming the one or more further regions 700 can be applied to other structures where an insulator disposed upon a substrate is overgrown with a polycrystalline semiconductor material. This technique is particularly useful where a monocrystalline semiconductor material is formed by a process of lateral epitaxial growth.

Even after the CMP stage described above, the one or more recesses 600, 702 described in the above two embodiments remain to a depth of at least 0.3µm.

It is thus possible to provide a Silicon-On-Oxide wafer produced using a so-called Lateral Epitaxial Growth over Oxide (LEGO) fabrication technique that therefore requires fewer process steps than existing processes for fabricating a silicon-on-oxide wafer. Further, the processing technique uses a standard bulk silicon substrate as raw material, thereby reducing production costs. Additionally, since the dielectric material used as the insulating material need not necessarily be oxide, and/or indeed insulating materials can be deposited together on the same silicon substrate and/or patterned, greater design flexibility is afforded. The provision of an alignment region facilitates accurate fabrication of sensor devices.

Although specific examples of insulators have been set forth herein, it should be appreciated that any suitable insulating material can be employed that can withstand the temperature of the re-crystallisation stage.

## Claims

1. A method of fabricating a silicon-on-insulator structure for a sensor, the method comprising:
providing a substrate (102); wherein the method is **characterised by** the steps of:
forming (200) a polysilicon seed layer (106) on an insulating material layer(104), the insulating material layer (104) being formed on the substrate (102) and arranged with the polysilicon seed layer (106) so as to leave a peripheral surface region of the substrate not covered by the insulating material layer (104) and the polysilicon seed layer (106);
growing (206) silicon over the polysilicon seed layer (106) and the surface region of the substrate not covered by the insulating material, thereby forming a region of monocrystalline silicon (108) and a region of polysilicon (110);
heating (210) the region of monocrystalline silicon (108) and the region of polysilicon (110) in a Rapid Thermal Processing (RTP) furnace for a predetermined period of time so as to cause the region of polysilicon (110) to re-crystallise into monocrystalline silicon.

2. A method as claimed Claim 1, wherein the region of monocrystalline silicon (108) is formed over the region of the substrate not covered by the insulating material, and the region of polysilicon (110) is formed over the polysilicon seed layer (106), respectively.

3. A method as claimed in Claim 1 or Claim 2, wherein the step of forming the insulating material layer (104) adjacent the substrate (102) comprises the step of:
patterning the substrate (102) with a first insulating material (400).

4. A method as claimed in Claim 3, further comprising the step of:
patterning the substrate (102) with a second insulating material (402).

5. A method as claimed in Claim 4, wherein a portion of the second insulating material pattern (402) is disposed adjacent a portion of the first insulating material pattern (400).

6. A method as claimed in Claim 5, wherein the portion of the second insulating material (402) is surrounded by the portion of the first insulating material (400).

7. A method as claimed in Claim 3 or Claim 4, wherein the first insulating material (400) is a dielectric and/or the second insulating material (402) is a dielectric.

8. A method as claimed in Claim 3, wherein the first insulting material (400) is an oxide.

9. A method as claimed in Claim 4, wherein the second insulating material (402) is a nitride.

10. A method as claimed in Claim 8, wherein the oxide is silicon oxide.

11. A method as claimed in Claim 9, wherein the nitride is silicon nitride or tantalum nitride.

12. A method as claimed in any one of the preceding claims, further comprising the step of:
depositing (208) a capping layer (112) adjacent the overgrown silicon (110) prior to heating the overgrown silicon.

13. A method as claimed in any one of the preceding claims, wherein the step of growing (206) the silicon comprises:
growing (206) the silicon to a thickness of at least 10µm.

14. A method as claimed in any one of the preceding claims, further comprising the step of forming a recess (600) in the substrate (102) prior to the selective deposition of the insulating material for facilitating alignment.

## Patentansprüche

1. Verfahren eines Herstellens einer Silizium-auf-Isolator-Struktur für einen Sensor, wobei das Verfahren umfasst:
Bereitstellen eines Substrates (102); wobei das Verfahren durch die folgenden Schritte **gekennzeichnet** ist:
Bilden (200) einer Polysiliziumsaatschicht (106) auf einer Isoliermaterialschicht (104), wobei die Isoliermaterialschicht (104) auf dem Substrat (102) gebildet wird und so mit der Polysiliziumsaatschicht (106) angeordnet wird, dass ein peripherer Oberflächenbereich des Substrates übrig bleibt, der nicht durch die Isoliermaterialschicht (104) und die Polysiliziumsaatschicht (106) bedeckt wird;
Züchten (206) von Silizium über die Polysiliziumsaatschicht (106) und den Oberflächenbereich des Substrates, der nicht durch das Isoliermaterial bedeckt wird, wodurch ein Bereich von monokristallinem Silizium (108) und ein Bereich von Polysilizium (110) gebildet werden;
Erhitzen (210) des Bereiches von monokristallinem Silizium (108) und des Bereiches von Polysilizium (110) in einem RTP-Ofen (RTP = Schnellwärmeverarbeitung) für eine vorbestimmte Zeitperiode, um so zu bewirken, dass der Bereich von Polysilizium (110) in monokristallines Silizium umkristallisiert.

2. Verfahren gemäß Anspruch 1, wobei der Bereich von monokristallinem Silizium (108) über den Bereich des Substrates gebildet wird, der nicht durch das Isoliermaterial bedeckt wird, und der Bereich von Polysilizium (110) über die Polysiliziumsaatschicht (106) gebildet wird.

3. Verfahren gemäß Anspruch 1 oder Anspruch 2, wobei der Schritt eines Bildens der Isoliermaterialschicht (104) angrenzend an das Substrat (102) den folgenden Schritt umfasst:
Mustern des Substrates (102) mit einem ersten Isoliermaterial (400).

4. Verfahren gemäß Anspruch 3, das weiterhin den folgenden Schritt umfasst:
Mustern des Substrates (102) mit einem zweiten Isoliermaterial (402).

5. Verfahren gemäß Anspruch 4, wobei ein Teil des zweiten Isoliermaterialmusters (402) angrenzend an einen Teil des ersten Isoliermaterialmusters (400) angeordnet wird.

6. Verfahren gemäß Anspruch 5, wobei der Teil des zweiten Isoliermaterials (402) durch den Teil des ersten Isoliermaterials (400) eingekreist wird.

7. Verfahren gemäß Anspruch 3 oder Anspruch 4, wobei das erste Isoliermaterial (400) und/oder das zweite Isoliermaterial (402) ein Dielektrikum sind.

8. Verfahren gemäß Anspruch 3, wobei das erste Isoliermaterial (400) ein Oxid ist.

9. Verfahren gemäß Anspruch 4, wobei das zweite Isoliermaterial (402) ein Nitrid ist.

10. Verfahren gemäß Anspruch 8, wobei das Oxid Siliziumoxid ist.

11. Verfahren gemäß Anspruch 9, wobei das Nitrid Siliziumnitrid oder Tantalnitrid ist.

12. Verfahren gemäß einem der vorangehenden Ansprüche, das weiterhin den folgenden Schritt umfasst:
Aufbringen (208) einer Kappenschicht (112) angrenzend an dem überwachsenen Silizium (110) vor einem Erwärmen des überwachsenen Siliziums.

13. Verfahren gemäß einem der vorangehenden Ansprüche, wobei der Schritt des Züchtens (206) des Siliziums umfasst:
Züchten (206) des Siliziums bis zu einer Dicke von mindestens 10 µm.

14. Verfahren gemäß einem der vorangehenden Ansprüche, das weiterhin den Schritt eines Bildens einer Aussparung (600) in dem Substrat (102) vor dem selektiven Aufbringen des Isoliermaterials zum Ermöglichen einer Anordnung umfasst.

## Revendications

1. Procédé de fabrication d'une structure silicium-sur-isolant pour un capteur, le procédé comprenant :
la fourniture d'un substrat (102) ; où le procédé est **caractérisé par** les étapes de :
formation (200) d'une couche de germe de polysilicium (106) sur une couche de matériau isolant (104), la couche de matériau isolant (104) étant formée sur le substrat (102) et disposée avec la couche de germe de polysilicium (106) de manière à laisser une région de surface périphérique du substrat non recouverte par la couche de matériau isolant (104) et la couche de germe de polysilicium (106) ;
croissance (206) de silicium sur la couche de germe de polysilicium (106) et la région de surface du substrat non recouverte par le matériau isolant, en formant ainsi une région de silicium monocristallin (108) et une région de polysilicium (110) ;
chauffage (210) de la région de silicium monocristallin (108) et de la région de polysilicium (110) dans un four de traitement thermique rapide (TTR) pendant une durée prédéterminée de manière à amener la région de polysilicium (110) à recristalliser en silicium monocristallin.

2. Procédé selon la revendication 1, où la région de silicium monocristallin (108) est formée sur la région du substrat non recouverte par le matériau isolant, et la région de polysilicium (110) est formée sur la couche de germe de polysilicium (106), respectivement.

3. Procédé selon la revendication 1 ou la revendication 2, où l'étape de formation de la couche de matériau isolant (104) adjacente au substrat (102) comprend l'étape de :
munir d'un motif le substrat (102) avec un premier matériau isolant (400).

4. Procédé selon la revendication 3, comprenant en outre l'étape de :
munir d'un motif le substrat (102) avec un second matériau isolant (402).

5. Procédé selon la revendication 4, où une partie du motif de second matériau isolant (402) est disposée de manière adjacente à une partie du motif de premier matériau isolant (400).

6. Procédé selon la revendication 5, où la partie du second matériau isolant (402) est entourée par la partie du premier matériau isolant (400).

7. Procédé selon la revendication 3 ou la revendication 4, où le premier matériau isolant (400) est un diélectrique et/ou le second matériau isolant (402) est un diélectrique.

8. Procédé selon la revendication 3, où le premier matériau isolant (400) est un oxyde.

9. Procédé selon la revendication 4, où le second matériau isolant (402) est un nitrure.

10. Procédé selon la revendication 8, où l'oxyde est de l'oxyde de silicium.

11. Procédé selon la revendication 9, où le nitrure est du nitrure de silicium ou du nitrure de tantale.

12. Procédé selon l'une quelconque des revendications précédentes, comprenant en outre l'étape de :
dépôt (208) d'une couche de revêtement (112) adjacente au silicium de recouvrement (110) avant le chauffage du silicium de recouvrement.

13. Procédé selon l'une quelconque des revendications précédentes, où l'étape de croissance (206) du silicium comprend :
la croissance (206) du silicium jusqu'à une épaisseur d'au moins 10 µm.

14. Procédé selon l'une quelconque des revendications précédentes, comprenant en outre l'étape de formation d'un évidement (600) dans le substrat (102) avant le dépôt sélectif du matériau isolant pour faciliter l'alignement.
